(19) Europäisches Patentamt
European Patent Office
Office européen des brevets

(11) **EP 3 389 096 A1**

(12) **EUROPEAN PATENT APPLICATION**

(43) Date of publication:
**17.10.2018 Bulletin 2018/42**

(51) Int Cl.:
*H01L 31/0224* (2006.01)     *H01L 51/00* (2006.01)
*H01L 51/44* (2006.01)     *H01L 31/0352* (2006.01)
*H01L 31/0749* (2012.01)

(21) Application number: **17166454.3**

(22) Date of filing: **13.04.2017**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(71) Applicant: **Nederlandse Organisatie voor
toegepast-
natuurwetenschappelijk onderzoek TNO
2595 DA 's-Gravenhage (NL)**

(72) Inventors:
• **Lifka, Herbert
2595 DA's-Gravenhage (NL)**

• **Veenstra, Siegfried Christiaan
2595 DA's-Gravenhage (NL)**
• **Dorenkamper, Maarten Sander
2595 DA's-Gravenhage (NL)**
• **Andriessen, Hieronymus Antonius Josephus
Maria
2595 DA's-Gravenhage (NL)**
• **Van den Heuvel, Huibert Johan
2595 DA's-Gravenhage (NL)**

(74) Representative: **V.O.
P.O. Box 87930
Carnegieplein 5
2508 DH Den Haag (NL)**

(54) **PHOTO-VOLTAIC ELEMENT AND METHOD OF MANUFACTURING THE SAME**

(57)     A photo-voltaic element (1) comprising a stack of layers is provided. The stack of layers at least includes the following layers arranged in the order named: a first electrode layer, a first charge carrier transport layer, an insulating layer, a second electrode layer, an second charge carrier transport layer, and a photo-electric conversion layer. The photo-electric conversion layer (70), comprises a plurality of distributed extensions (72) extending through the second charge carrier transport layer (60), the second electrode layer (50) and the insulating layer (40) to the first charge carrier transport layer (30). The extensions (72) have an effective cross-section $D_{eff}$ in the range of 0.5 to 10 micron, and have an average pitch in the range of 1.1 to 5 times said effective cross-section.

FIG. 7

EP 3 389 096 A1

**Description**

BACKGROUND OF THE INVENTION

Field of the invention

The present invention pertains to a photo-voltaic element.
The present invention further pertains to a method of manufacturing the same.

Related Art

A photo-voltaic element is disclosed in CN105140398 that comprises a conductive substrate; a uniform electron transport layer; a dielectric layer; a metal layer; and a perovskite layer as a photo-electric conversion layer. The latter has a plurality of channels through the dielectric layer and the metal layer that contact the electron transport layer. Accordingly the perovskite photo-electric conversion layer has its electric contacts for delivering electrical energy at the same side. Therewith it can be avoided that light to be converted has to pass through an electrode layer, as a result of which it would be attenuated before conversion.
The cited document also presents a method of manufacturing the photo-voltaic element disclosed therein. Therein a substrate is provided of a transparent conductive glass and an electron transport layer is deposited thereon by magnetron sputtering ZnO. Subsequently a layer of dispersed PS pellets having an original diameter of 2 um is deposited resulting in a hexagonal close-packed structure of said PS pellets. The PS ball diameter is subsequently reduced to 1 um by dry etching using RIE. A dielectric layer of Al2O3 is deposited thereon using ALD deposition followed by magneton sputtering of an Au layer. Subsequently, using a solvent and an ultrasonic treatment the PS pellets and the portions of the Al2O3 layer and the Au layer deposited thereon are removed, so that an Au mesh is obtained that is insulated from the electron transport layer. A perovskite layer is spin coated thereon that both contacts the Au mesh and the ZnO electron transport layer.

SUMMARY OF THE INVENTION

It is a first object of the invention to provide a photo-voltaic element with an improved conversion efficiency.
It is a second object of the invention to provide a method of manufacturing this improved photo-voltaic element.
In accordance with said first object, according to a first aspect, a photo-voltaic element is provided as claimed in claim 1.
In accordance with said second object, according to a second aspect, a method of manufacturing a photo-voltaic element is provided as claimed in claim 8.

The photo-voltaic element is provided as claimed in claim 1 comprises a stack of layers that at least include in the order named: a first electrode layer, a first charge carrier transport layer, an insulating layer, a second electrode layer, an second charge carrier transport layer, and a photo-electric conversion layer.
The first electrode layer is provided for receiving charge carriers of a first polarity, for example electrons, or alternatively for receiving holes as the charge carrier. The first charge carrier transport layer is provided for transport of charge carriers having the first polarity. E.g. if the first electrode layer is a cathode provided for receiving electrons as the charge carrier then the first charge carrier transport layer is an electron transport layer. Alternatively, if the first electrode layer is an anode provided for receiving holes as the charge carrier then the first charge carrier transport layer is a hole transport layer. The insulating layer may be provided of any sufficiently insulating organic or inorganic material. The second electrode layer is provided for receiving charge carriers of a second polarity opposite to the first polarity. Hence if the first electrode layer is a cathode then the second electrode layer is an anode and vice versa. The second charge carrier transport layer is provided for transport of charge carriers having the second polarity. Accordingly the second charge carrier transport layer is a hole transport layer if the second electrode layer is an anode and an electron transport layer if the second electrode layer is a cathode. The photo-electric conversion layer comprises a plurality of distributed extensions that extend through the second charge carrier transport layer, the second electrode layer and the insulating layer to the first charge carrier transport layer.
Therewith the photo-electric conversion layer is electrically coupled to both the first charge carrier transport layer and the second charge carrier transport layer. In this arrangement solar radiation R does not need to traverse an electrode layer or a charge carrier transport layer, which contributes to an efficient operation of the photo-voltaic element.
An optimal conversion efficiency is achieved by the presence of a charge carrier transport layer between the first electrode layer and the photo-electric conversion layer as well as between the second electrode layer and the photo-electric conversion layer.
The extensions have an effective cross-section $D_{eff}$ in the range of 0.5 to 10 micron, and have an average pitch in the range of 1.1 to 5 times their effective cross-section. The effective cross-section is defined here as the diameter of a circle having an area corresponding to the cross-sectional area $A_{\varnothing}$ of the extensions. I.e.

$$D_{eff} = \sqrt{\frac{4A_{\Phi}}{\pi}}$$

The extensions are typically cylindrical. Alternatively the extensions may taper inward or outward. The extensions may have any cross-section, such as circular, square or triangular. Preferably, a circumference O of the extensions is less than 10 times the effective diameter $D_{eff}$ and even more preferably less than 5 times the effective diameter $D_{eff}$. Therewith an optimum contact surface between the photo-electric conversion layer and the first charge carrier transport layer is achieved with minimum disruption of the intermediary layers, in particular the second electrode layer and the second charge carrier transport layer.

In an embodiment the photo-electric conversion layer is provided of a perovskite material. Perovskite materials typical have a crystal structure of $ABX_3$, wherein A is an organic cation as methylammonium $(CH_3NH_3)^+$, B is an inorganic cation, usually lead (II) $(Pb^{2+})$, and X is a halogen atom such as iodine $(I^-)$, chlorine $(Cl^-)$ or bromine $(Br^-)$. Perovskite materials are particularly advantageous in that they can be processed relatively easily and in that their bandgap can be set to a desired value by a proper choice of the halide content. A typical example is methylammonium lead trihalide $(CH_3NH_3PbX_3)$, with an optical bandgap between 1.5 and 2.3 eV depending on halide content. Another more complex structure example is Cesium -formamidinum lead trihalide $(C_{S0.05}(H_2NCHNH_2)_{0.95}PbI_{2.85}Br_{0.15})$ having a bandgap between 1.5 and 2.2 eV. Other metals such as tin may replace the role of Pb in perovskite materials. An example thereof is $CH_3NH_3SnI_3$. Also combinations of Sn with Pb perovskites having a wider bandgap in the range of 1.2 to 2.2 eV are possible. In another embodiment the photo-electric conversion layer is made of copper indium gallium selenide (CIGS).

The method as claimed in claim 8 enables manufacturing the photo-voltaic element of claim 1. The claimed method comprises the steps of:

- providing a substrate;
- depositing thereon a stack of layers comprising at least in the order named:
- a first electrode layer for receiving charge carriers of a first polarity;
- a first charge carrier transport layer, for transport of charge carriers having said first polarity;
- an insulating layer;
- a second electrode layer for receiving charge carriers of a second polarity opposite to said first polarity;
- an second charge carrier transport layer, for transport of charge carriers having said second polarity;

wherein the insulating layer and layers subsequently deposited in this step form a sub-stack having an upper surface,

- applying a resist layer on said upper surface, wherein said resist layer is provided with a plurality of distributed openings towards said upper surface, the openings having an effective cross-section D in the range of 0.5 to 10 micron, and having an average pitch in the range of 1.1 to 5 times said effective cross-section,

- etching to selectively remove material of the sub-stack facing the openings,
- removing the resist layer subsequent to said etching,
- depositing and curing a photo-electric conversion layer subsequent to said removing.

The method according to the present invention enables the deposition of a thicker stack of layers on the first charge carrier transport layer than would be possible when using the pellet based approach known from the prior art. In this way the second charge carrier transport layer can be provided, therewith significantly improving efficiency of the photo-voltaic element.

Various methods may be used for depositing and applying layers. These methods may include spin-coating, printing methods, slot-die coating and vapor deposition methods like physical vapor deposition (e.g. E-beam PVD, Sputter PVD), (spatial) Atomic Layer Deposition ((s)ALD), and chemical vapor deposition (e.g. plasma-enhanced chemical vapor deposition (PECVD)).

Etching processes may be applied to remove a material (or a part of the material) from a surface either by a chemical reaction generated by the use of a reactive mix of gases (plasma-etching) or by submerging the substrates in a reactive solution where the layer is removed by dissolution or chemical reaction (wet-etching).

A selective etching is made possible by using a mask that locally protects the underlying layer(s). A patterning in such a mask may be obtained for example by optical lithography wherein light is used to transfer a geometric pattern from a photo-mask to a light sensitive chemical photoresist on the substrate. Also imprinting can be applied to pattern the mask. Alternatively the mask may be directly applied in the desired pattern, for example by printing.

BRIEF DESCRIPTION OF THE DRAWINGS

These and other aspects are described in more detail with reference to the drawing. Therein:

FIG. 1A schematically shows a top-view of a semi-finished product obtained during performing a method according to the second aspect,
FIG. 1B shows a cross-section according to IB-IB in FIG. 1A,
FIG. 2A shows a top-view corresponding to the area IIA of a semi-finished product obtained after an additional manufacturing step of a method according to the second aspect,
FIG. 2B shows a cross-section according to IIB-IIB in FIG. 2A,
FIG. 3A shows a top-view corresponding to the area IIA of a semi-finished product obtained after a further additional manufacturing step of a method according to the second aspect,

FIG. 3B shows a cross-section according to IIIB-IIIB in FIG. 3A,

FIG. 4A shows a top-view corresponding to the area IIA of a semi-finished product obtained after a still further additional manufacturing step of a method according to the second aspect,

FIG. 4B shows a cross-section according to IVB-IVB in FIG. 4A,

FIG. 4C shows in the same cross-section an optional manufacturing step of a method according to the second aspect,

FIG. 4D shows in the same cross-section an alternative optional manufacturing step of a method according to the second aspect,

FIG. 4E shows in the same cross-section a subsequent alternative optional manufacturing step of a method according to the second aspect,

FIG. 4F shows in the same cross-section an further subsequent alternative optional manufacturing step of a method according to the second aspect,

FIG. 4G shows in the same cross-section an alternative embodiment resulting from a still further subsequent alternative optional manufacturing step following the step illustrated in FIG. 4F,

FIG. 5 shows in the same cross-section a first embodiment of a photo-voltaic element according to the first aspect obtained after a further manufacturing step of a method according to the second aspect,

FIG. 6 shows in the same cross-section a second embodiment of a photo-voltaic element according to the first aspect,

FIG. 7 shows in the same cross-section a third embodiment of a photo-voltaic element according to the first aspect,

FIG. 8A shows a top-view corresponding to the area IIA of a fourth embodiment of a photo-voltaic element according to the first aspect,

FIG. 8B shows a cross-section according to VIIIB-VIIIB in FIG. 8A.

DETAILED DESCRIPTION OF EMBODIMENTS

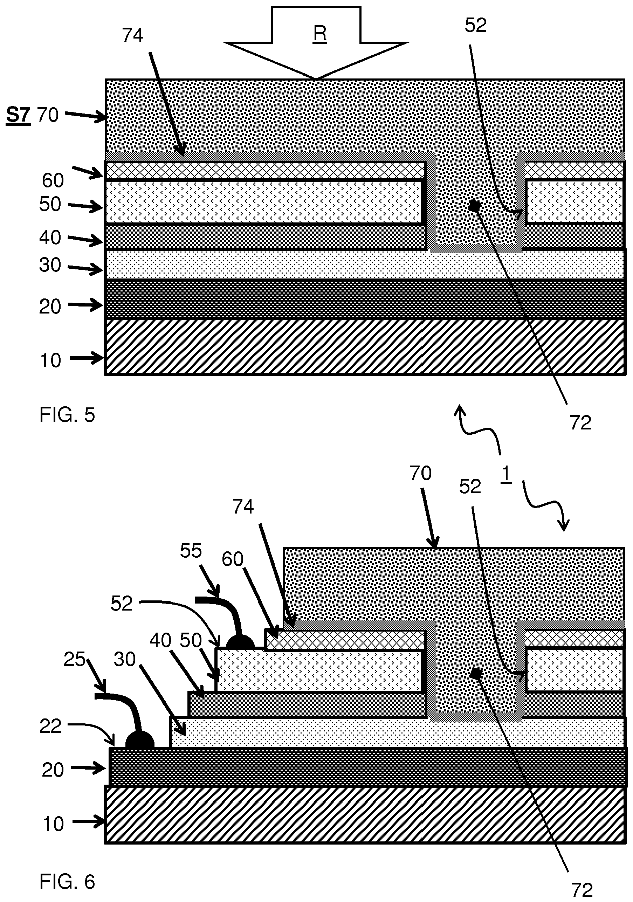

Fig. 5 schematically shows a photo-voltaic element 1. The photo-voltaic element 1 comprises a substrate 10 and a stack of layers arranged thereon. The substrate 10 may be formed of a rigid material such as a metal (e.g. steel, copper or aluminum), silicon or glass or of a flexible material such as a polymer, e.g. a polymer like polyethylene terephthalate (PET), polyethylene naphthalate (PEN), or polyimide (PI). Also thin metal or glass are suitable substrates. If the substrate is conducting, an isolating layer may be deposited on that substrate to isolate the electrode from the substrate. Dependent on the application a thickness of the substrate may be selected in the range of a relatively small value e.g. 50 micron and a relatively large value, e.g. a few mm or more. The stack of layers subsequently includes at least a first electrode layer 20, a first charge carrier transport layer 30, an insulating layer 40, a second electrode layer 50, an second charge carrier transport layer 60, and a photo-electric conversion layer 70.

The first electrode layer 20 is provided for receiving charge carriers of a first polarity. In the embodiment shown the first electrode layer 20 is an anode, i.e. arranged for receiving holes as the charge carriers. Dependent on the lateral size of the photo-voltaic element 1 the first electrode layer 20 may for example have a thickness in the range of a few tens to a few hundreds of nanometers or even more. In the embodiment shown the first electrode layer 20 includes an aluminum sub layer having a thickness of 190 nm, which is sandwiched between a pair of nickel layers, each having a thickness of 5 nm. In another example the first electrode layer is of molybdenum. In an embodiment where the substrate is provided of a metal, it may also serve as a first electrode layer 20.

In the embodiment shown the first charge carrier transport layer 30 is a hole transport layer, having a thickness in the range of 10 to 200 nm. In the embodiment shown the hole transport layer is formed by a nickeloxide layer having a thickness of 50 nm. In another example the hole transport layer is formed by a MoSe layer.

An insulating layer 40 is provided of an organic, e.g. a polymer, or inorganic insulating material, such as a metal oxide. Also a stack of materials can be used. Dependent on the material selected for the insulating layer, it may have a thickness in the range of 10 to 200 nm for example, but also a substantially thicker insulating layer may be applied. In the embodiment shown the insulating layer 40 is provided as an $SiO_2$ layer having a thickness of 100 nm.

A second electrode layer 50 for receiving charge carriers of a second polarity opposite to said first polarity is arranged on the insulating layer 40. In this case the second electrode layer 50 is a cathode. Any sufficiently conducting material can be used for this purpose at a thickness depending on the lateral size of the photo-voltaic element 1. Typically the thickness of the second electrode layer 50 is of the same order of magnitude as the thickness of the first electrode layer 20, so that they have approximately the same conductivity and neither of them forms a bottleneck. In the embodiment shown the second electrode layer 50 is an aluminum layer with a thickness of 200 nm. In some embodiments the second electrode layer 50 may have a thickness greater than that of the first electrode layer 20, e.g. 1.5 times a thickness of the first electrode layer 20, to compensate for the presence of the openings provided in the second electrode layer 50.

A second charge carrier transport layer 60 for transport of charge carriers having said the second polarity, opposite to the first polarity layer is arranged upon the second electrode layer 50. In this case the second charge carrier transport layer 60 is an electron transport layer. The second charge carrier transport layer 60, here an electron transport layer may have a thickness in the range of a few nm, e.g. 5 nm to a few tens of nm, e.g. 50 nm. In the embodiment shown the second charge carrier transport layer 60 is a $TiO_2$ layer having thickness of 15 nm. Other suitable materials for an electron transport layer are for example $SnO_2$, $ZrO_2$ and ZnO:S.

A photo-electric conversion layer 70 is provided upon the second charge carrier transport layer 60. The photo-electric conversion layer 70 has a plurality of distributed, typically cylindrical, extensions 72 that extend through the second charge carrier transport layer 60, the second electrode layer 50 and the insulating layer 40 to the first charge carrier transport layer 30. Therewith the photo-electric conversion layer 70 is electrically coupled to both the first charge carrier transport layer 30 and the second charge carrier transport layer 60. In this arrangement solar radiation R does not need to traverse an electrode layer or a charge carrier transport layer which contributes to an efficient operation of the photo-voltaic element 1. In the embodiment shown the extensions 72 have an effective cross-section $D_{eff}$ in the range of 0.5 to 10 micron, and have an average pitch in the range of 1.1 to 5 times their effective cross-section. The effective cross-section is defined here as the diameter of a circle having an area corresponding to the cross-sectional area $A_\varnothing$ of the extensions.
I.e.

$$D_{eff} = \sqrt{\frac{4A_\Phi}{\pi}}$$

The extensions may have any cross-section, such as circular, square or triangular. Preferably, a circumference O of the extensions is less than 10 times the effective diameter $D_{eff}$ and even more preferably less than 5 times the effective diameter $D_{eff}$.

In the embodiment the photo-electric conversion layer is provided of a perovskite material, such as methylammonium lead trihalide ($CH_3NH_3PbX_3$), or Cesium-formamidinum lead trihalide ($Cs_{0.05}(H_2NCHNH_2)_{0.95}PbI_{2.85}Br_{0.15}$) .. Alternatively a tin based perovskite material, such as $CH_3NH_3SnI_3$ may be used. Also more complex perovskite materials may be applied, for example containing a combination of different cations. Also other materials, such as copper indium gallium selenide (CIGS) are suitable.

In the embodiment shown the second electrode layer 50 has anodized edge surfaces 52 facing the extensions 72 of the photo-electric conversion layer 70. This avoids direct contact between the second electrode layer and the photo-electric conversion layer.

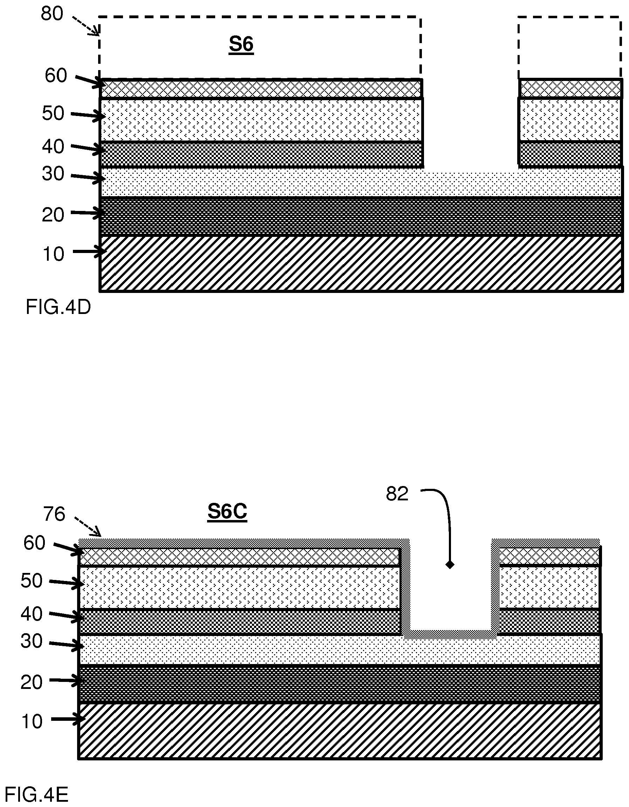

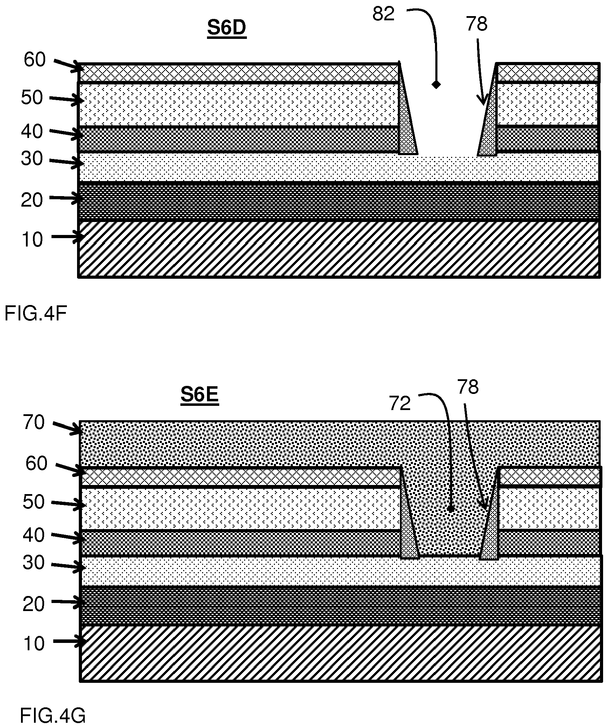

FIG. 4G illustrates an alternative embodiment wherein such direct contact is avoided. Therein the openings 82 are provided with an insulating wall 78, e.g. of a ceramic material. The specific steps for manufacturing this embodiment are described in more detail below with reference to FIG. 4D to FIG. 4G.

FIG. 6 shows an embodiment of the photo-voltaic element 1 of the invention wherein an edge portion 22 of an upper surface of the first electrode layer 20 is kept free from material of the first charge carrier transport layer 30 and is provided with a first electrical contact 25. Also an edge portion 52 of an upper surface of the second electrode layer 50 is kept free from material of the second charge carrier transport layer 60 and is provided with a second electrical contact 55. Another possibility is to remove the carrier transport layer 30 and isolator 40 with e.g. laser ablation before deposition of electrode 50, so a contact can be made from electrode 50 to electrode 20. Also before deposition of charge carrier transport layer 30 a laser step could be used to interrupt the electrode 20.

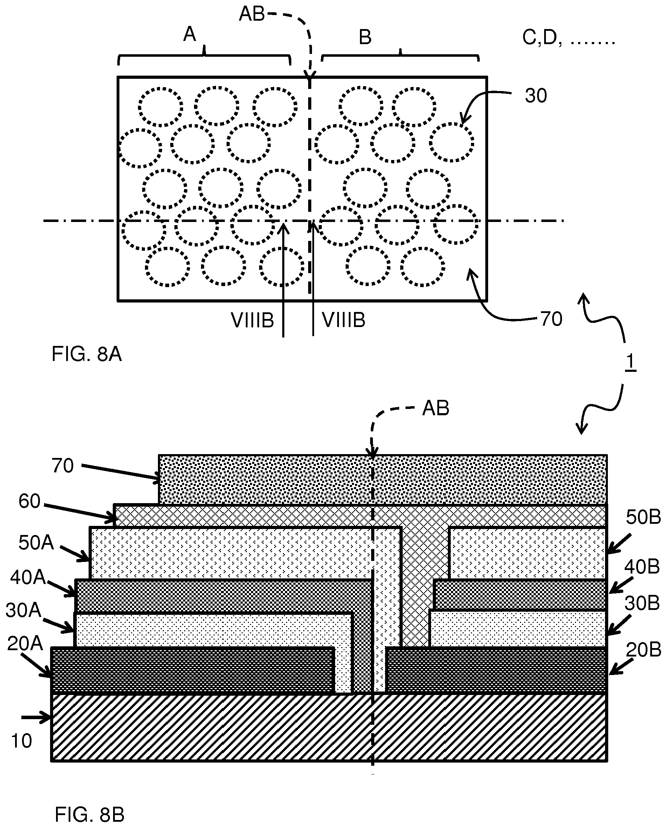

FIGs. 8A and 8B show a further embodiment of a photo-voltaic element according to the invention. Therein FIG. 8A shows a top-view and FIG. 8B shows a cross-section of a portion of the device according to VIIIB-VIIIB in FIG. 8A. In this further embodiment the first electrode layer 20, the first charge carrier transport layer 30, the insulating layer 40 and the second electrode layer 50 are provided as a plurality of layer segments. Therein a plurality of lateral sub-stack segments is formed. By way of example two lateral sub-stack segments A,B are shown in this case. However in practice the photo-voltaic element may have a larger number of lateral sub-stack segments C,D, ... e.g. 10 or 100 or more, depending on a required lateral size of the photo-voltaic element.

As shown in FIG. 8B each layer segment A,B comprises a first electrode layer segment 20A, 20B, a first charge carrier transport layer segment 30A, 30B, an insulating layer segment 40A, 40B and a second electrode layer segment 50A, 50B. The second charge carrier transport layer 60 and the photo-electric conversion layer 70 are formed as continuous layers. A second electrode layer segment 50A of a lateral sub-stack segment A extends over a first electrode layer segment (20B) in a neighboring sub-stack segment B. Therewith an electrical connection is formed between the second electrode layer segment 50A of the lateral sub-stack segment A and the first electrode layer segment 20B in the neighboring lateral sub-stack segment. In this way the photo-voltaic element is formed as a plurality of serially connected modules, which makes it possible to reduce resistive losses as compared to a photo-voltaic element that is not partitioned into serially connected modules. It could alternatively be contemplated to serially arrange a plurality of smaller photo-voltaic elements. It is however an advantage of the embodiment of FIG. 8A, 8B that external connection elements are avoided. A photo-voltaic element as shown in FIG. 8A, 8B could for example be provided as a single elongate product applied on a foil, e.g. delivered in a length of tens to hundreds of meter on a roll.

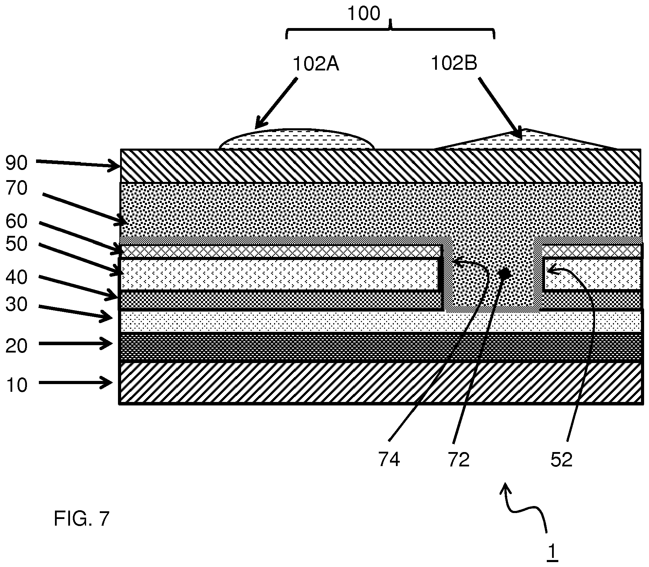

As shown in FIG. 7 additional layers may be provided. In the embodiment of FIG. 7 for example a barrier 90 is arranged over said photo-electric conversion layer 70. Suitable materials for the barrier are metal oxides, such as SiOx and SiNx. In practice the barrier 90 may comprise a plurality of layers, such as a stack of inorganic layers having a mutually different composition. Also a combination of inorganic layers and organic layers may be used. For example a barrier 90 may be formed by a first and a second inorganic layer that sandwich an organic layer. For a good light in coupling it is preferred that the materials used for the barrier 90 have a refractive index lower than that of the photo-electric conversion layer 70.

In the embodiment shown light in coupling is further improved by a light in coupling structure 100 arranged over the barrier 90. In the embodiment shown the light in coupling structure comprises a plurality of light in coupling elements 102A, 102B. For example semi-spherical or pyramidal shaped light in coupling elements may be used.

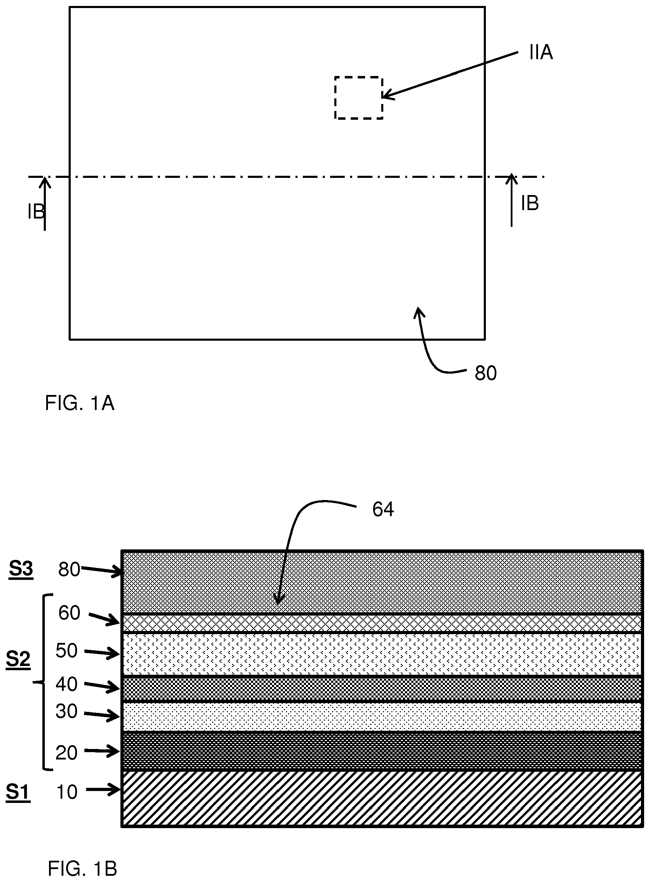

A method of manufacturing a photo-voltaic element is now disclosed with reference to FIG. 1 to 5.

FIG. 1A, 1B show the intermediate product obtained after a first three steps. Therein FIG. 1A shows a top-view and FIG. 1B shows a cross-section according to IB-IB in FIG. 1A.

Therein a substrate is 10 is provided in a first step S1. Then in a second step S2 a stack of layers is deposited thereon that comprise at least in the order named a first electrode layer 20, a first charge carrier transport layer 30, an insulating layer 40, a second electrode layer 50 and a second charge carrier transport layer.

The first electrode layer 20 is provided for receiving charge carriers of a first polarity. The first electrode layer 20 may for example be an anode, i.e. arranged for receiving holes as the charge carriers. Alternatively the first electrode layer 20 may be a cathode, i.e. arranged for receiving electrons as the charge carriers. In an embodiment the first electrode layer 20 is deposited with a PVD (physical vapor deposition) method, for example using E-beam PVD. In this example the first electrode layer 20 was provided as a stack of sub-layers obtained by subsequently depositing a first sub-layer of nickel having a thickness of 5 nm, an aluminum layer having a thickness of 190 nm and a second sub-layer of nickel also having a thickness of 5 nm. Then spin-coating (1000 rpm) was used to deposit a NiO layer as the first charge carrier transport layer 30, here a hole transport layer.

An insulating layer 40 was then deposited in a first and a second stage. In the first of these stages a first, 100 nm thick, sublayer of $SiO_x$ was deposited by electron-beam deposition and in the second stage a second sublayer of $SiO_x$, also having a thickness of 100 nm was deposited by PECVD. Then a second electrode layer 50, here a cathode layer of aluminum at a thickness of 200 nm was formed using the same method and conditions as those applied for the deposition of the aluminum sub-layer of the first electrode layer 20.

A second charge carrier transport layer 60, here an electron transport layer was then deposited. In this case electron-beam vapor deposition was used to deposit a $TiO_x$ layer with a thickness of 15 nm of linear titanium dioxide (TiOx).

The insulating layer 40 and the layers 50, 60 form a sub-stack having an upper surface 64. In a third step S3, here using spin coating a resist layer 80, here a photo-resist layer having a thickness of 1.6 micron was deposited on this upper surface 64. In other implementations the resist layer may be an imprint-resist layer.

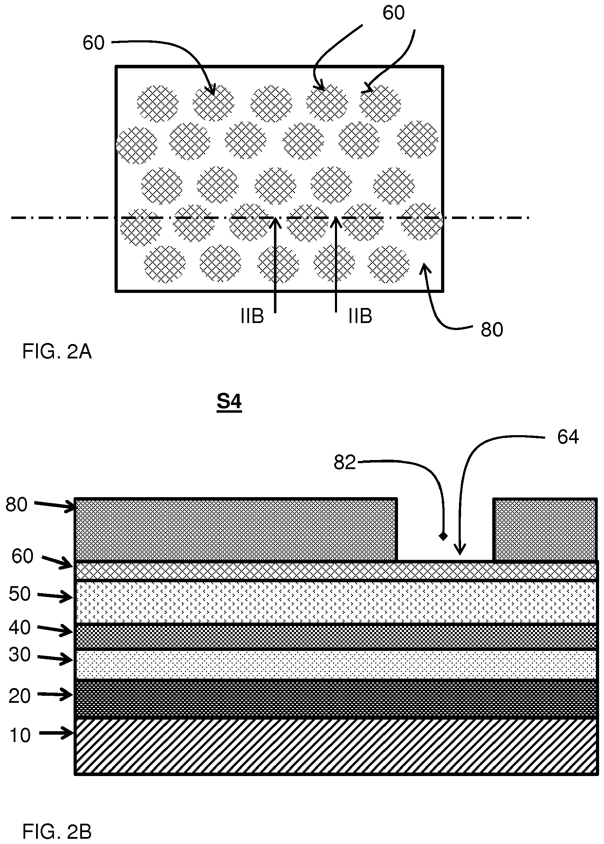

FIG. 2A, 2B show a subsequent step S4. Therein FIG. 2A shows a top-view of an intermediate product resulting from this step S4 and FIG. 2B shows a cross-section according to IIB-IIB in FIG. 2A. In this subsequent step regularly distributed openings 82 giving access to the upper surface 64 are formed in the resist layer 80. In this embodiment contact lithography was used for this purpose. Using the method described herewith samples were prepared having openings with diameter in the range of 0,5 - 5 $\mu$m and a distance between neighboring openings in the range of 1 - 5 $\mu$m. Therewith a pitch between 1 and 10 $\mu$m is obtained. The openings having an effective cross-section D in the range of 0.5 to 10 micron, and have an average pitch in the range of 1.1 to 5 times the effective cross-section.

Instead of patterning an originally homogeneous resist layer, it is alternatively possible to directly depositing the resist layer in the desired pattern, for example using a printing technique.

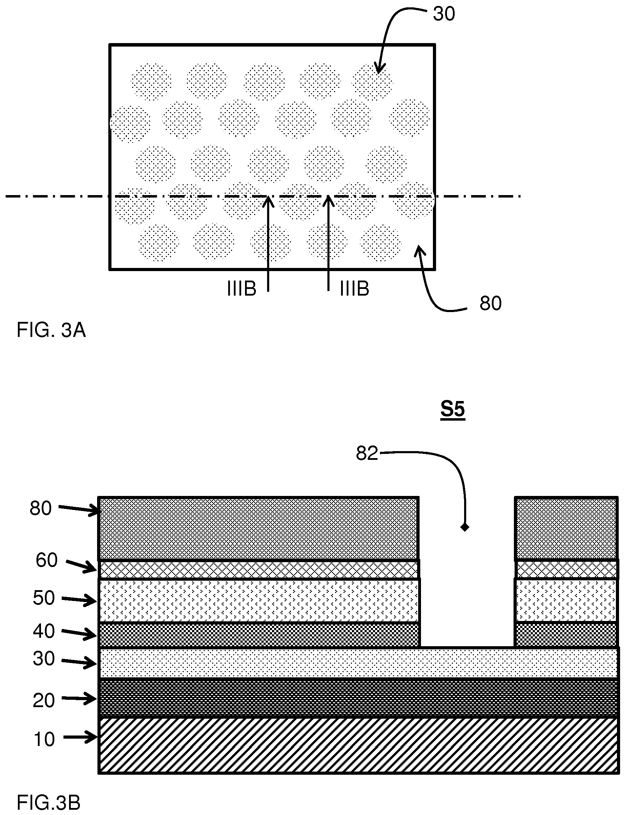

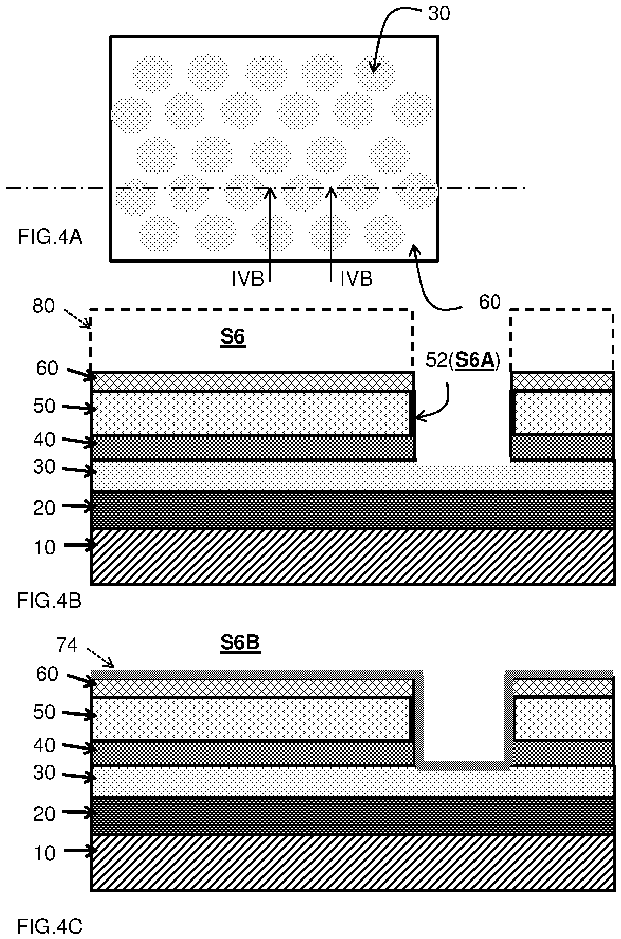

FIGs. 3A and 3B show a subsequent step S5, wherein material of the sub-stack 40, 50, 60 facing the openings 82 is selectively removed. Therein FIG. 3A shows a top-view of the semi-finished product obtained after this step S5 and FIG. 3B shows a cross-section according to IIIB-IIIB in FIG. 3A. Step S5 involves etching the upper layers 50, 60 by plasma etching. Then the insulating $SiO_x$ layer is etched with a further plasma etching process. The photo-resist layer 80 is then fully removed (Step S6), for example by oxygen plasma-etching as illustrated in FIGs. 4A and 4B. Therein FIG. 4A is a top-view and FIG. 4B shows a cross-section according to IVB-IVB in FIG. 4A.

As shown in FIG. 5, in a step S7, subsequent to this step S6, a photo-electric conversion layer 70 is deposited (for example by spin-coating) and cured. Optional pre-processing steps, S6A and S6B may be performed after removal of the resist layer 80 and before deposition of the photo-electric conversion layer 70.

A first optional pre-processing step S6A is illustrated in FIG. 4B. Therein an edge surface 52 of the second electrode layer 50 is anodized. This edge surface 52 was formed by the step of etching S5. This anodization process an insulating layer is formed on the edge surface 52 therewith avoiding a direct contact between the second electrode layer 50 and the photo-electric conversion layer 70.

FIG. 4C illustrates a second optional preprocessing step S6B. Therein to facilitate the deposition in step S7, an atomic layer deposition process (ALD) may be used to deposit a thin growth layer 74, e.g. applying a $TiO_2$ layer with a few sALD cycles.

FIG. 4D-4G shows an alternative approach for preventing a direct electrical contact between the second electrode layer 50 and the photo-electric conversion layer 70. After removal (S6) of the patterned resist layer 80 as shown in FIG. 4D, a layer 76 of an insulating material is conformally deposited (Step S6C) on the semi-finished product of FIG. 4D, therewith obtaining the semifinished product of FIG. 4E. Then an anisotropic etch step S6D, e.g. a plasma etch step is applied. The anisotropic etch step S6D removes the insulating material from the surface of the second charge carrier transport layer 60 and from the surface portions of the first charge carrier transport layer 30 within the openings 82 but keeps a layer of the insulating material on the walls of the openings 82 intact. Subsequent to this step S6D the photo-electric conversion layer can be deposited (S6E) as shown in FIG. 4G.

Upon completion the substrate 10 may be removed. For example this may be the case if an electrode layer, e.g. the first electrode layer 20 provides sufficient structural integrity. Alternatively, or in addition mechanical support may be provided by further layers applied on the photo-electric conversion layer 70.

While the invention has been illustrated and described in detail in the drawings and foregoing description, such illustration and description are to be considered illustrative and exemplary and not restrictive; the invention is not limited to the disclosed embodiments. Other variations to the disclosed embodiments can be understood and effected by those skilled in the art in practicing the claimed invention, from a study of the drawings, the disclosure and the appended claims.

In the claims the word "comprising" does not exclude other elements or steps, and the indefinite article "a" or "an" does not exclude a plurality. A single processor or other unit may fulfill the functions of several items recited in the claims. The mere fact that certain measures are recited in mutually different claims does not indicate that a combination of these measures cannot be used to advantage. Any reference signs in the claims should not be construed as limiting the scope.

**Claims**

1. A photo-voltaic element (1) comprising a stack of layers, the stack of layers at least including the following layers arranged in the order named:

   - a first electrode layer (20) for receiving charge carriers of a first polarity,
   - a first charge carrier transport layer (30), for transport of charge carriers having said first polarity,
   - an insulating layer (40),
   - a second electrode layer (50) for receiving charge carriers of a second polarity opposite to said first polarity,
   - a second charge carrier transport layer (60), for transport of charge carriers having said second polarity,
   - a photo-electric conversion layer (70), comprising a plurality of distributed extensions (72) extending through said second charge carrier transport layer (60), said second electrode layer (50) and said insulating layer (40) to the first charge carrier transport layer (30), the extensions (72) having an effective cross-section $D_{eff}$ in the range of 0.5 to 10 micron, and having an average pitch in the range of 1.1 to 5 times said effective cross-section.

2. The photo-voltaic element according to claim 1, wherein said second electrode layer (50) has anodized edge surfaces (52) facing the extensions (72) of the photo-electric conversion layer (70).

3. The photo-voltaic element according to claim 1, wherein an insulating material is provided around said extensions (72), forming an insulating wall (78) between said second electrode layer (50) and said photo-electric conversion layer (70).

4. The photo-voltaic element according to claim 1, 2 or 3, further comprising a growth layer (74) at an interface between said photo-electric conversion layer (70) and said second charge carrier transport layer (60) as well as at an interface between said extensions (72) of the photo-electric conversion layer and each of edge surfaces of said second charge carrier transport layer (60), said second electrode layer (50) and said insulating layer (40) and at an interface between said extensions of the photo-electric conversion layer and the first charge carrier transport layer (30).

5. The photo-voltaic element according to one of the previous claims, wherein the photo-electric conversion layer is provided of a perovskite material.

6. The photo-voltaic element according to one of the previous claims, wherein the photo-electric conversion layer is made of copper indium gallium selenide (CIGS).

7. The photo-voltaic element according to one of the previous claims, wherein an edge portion of an upper surface of the first electrode layer (20) is kept free from material of the first charge carrier transport layer (30) and is provided with a first electrical contact (25) and or an edge portion of an upper surface of the second electrode layer (50) is kept free from material of the second charge carrier transport layer (60) and is provided with a second electrical contact (55).

8. The photo-voltaic element according to one of the previous claims, wherein said first electrode layer (20), said first charge carrier transport layer (30), said insulating layer (40) and said second electrode layer (50) are provided as a plurality of layer segments, wherein a plurality of lateral sub-stack segments each comprise a respective first electrode layer segment (20A, 20B), a first charge carrier transport layer segment (30A, 30B), an insulating layer segment (40A, 40B) and a second electrode layer segment (50A, 50B), wherein a second electrode layer segment (50A) of a lateral substack segment extends over a first electrode layer segment (20B) in a neighboring sub-stack segment, therewith forming an electrical connection between said second electrode layer segment (50A) of said lateral sub-stack segment and said first electrode layer segment (20B) in said neighboring lateral sub-stack segment.

9. Method of manufacturing a photo-voltaic element comprising the steps of:

- providing (S1) a substrate (10);
- depositing (S2) thereon a stack of layers comprising at least in the order named:
- a first electrode layer (20) for receiving charge carriers of a first polarity;
- a first charge carrier transport layer (30), for transport of charge carriers having said first polarity;
- an insulating layer (40);
- a second electrode layer (50) for receiving charge carriers of a second polarity opposite to said first polarity;
- an second charge carrier transport layer (60), for transport of charge carriers having said second polarity;

wherein the insulating layer and layers subsequently deposited in this step form a substack having an upper surface (64),

- applying (S3) a resist layer (80) on said upper surface, wherein said resist layer is provided (S4) with a plurality of distributed openings (82) towards said upper surface, the openings having an effective cross-section D in the range of 0.5 to 10 micron, and having an average pitch in the range of 1.1 to 5 times said effective cross-section,
- etching (S5) to selectively remove material of the sub-stack facing the openings (82),
- removing (S6) the resist layer subsequent to said etching,

- depositing (S7) and curing a photo-electric conversion layer (70) subsequent to said removing.

10. The method according to claim 9, further comprising anodizing (S6A) an edge surface of the second electrode layer resulting from said etching, said anodizing being performed prior to the step of depositing the photo-electric conversion layer.

11. The method according to claim 9, further comprising conformally depositing (S6C) a layer (76) of an insulating material subsequent to said step of etching (S5) and anisotropically etching (S6D) said layer (76) to removes the insulating material from the surface of the second charge carrier transport layer (60) and from the surface portions of the first charge carrier transport layer (30) within the openings (82) while keeping a layer (78) of the insulating material on the walls of the openings (82) intact.

12. The method according to claim 9, 10 or 11, further comprising depositing (S6B) a growth layer (74) subsequent to said step of etching (S5) and prior to the step of depositing (S7) the photo-electric conversion layer.

13. The method according to one of the claims 9-12, further comprising depositing a barrier (90) over said photo-electric conversion layer.

14. The method according to claim 13, wherein said barrier (90) has a refractive index lower than a refractive index of said photo-electric conversion layer.

15. The method according to claim 13 or 14, comprising applying a light in coupling structure (100) over said barrier.

16. The method according to claim 15, wherein said light in coupling structure comprises a plurality of light in coupling elements.

17. The method according to one of the claims 9-16, wherein the photo-electric conversion layer (70) is provided of a perovskite material or of copper indium gallium selenide (CIGS).

IIA

IB

IB

80

FIG. 1A

64

**S3** 80

60
**S2** 50
40
30
20

**S1** 10

FIG. 1B

FIG. 2A

**S4**

FIG. 2B

30

80

IIIB    IIIB

FIG. 3A

S5

82

80
60
50
40
30
20
10

FIG.3B

FIG.4A

30

IVB          IVB

80                                    60

**S6**

60                          52(**S6A**)

50

40

30

20

10

FIG.4B

74          **S6B**

60

50

40

30

20

10

FIG.4C

80

S6

60

50

40

30

20

10

FIG.4D

76

S6C

82

60

50

40

30

20

10

FIG.4E

**S6D**

82    78

60
50
40
30
20
10

FIG.4F

**S6E**

72    78

70
60
50
40
30
20
10

FIG.4G

FIG. 5

FIG. 6

100

102A          102B

90

70

60

50

40

30

20

10

74    72        52

1

FIG. 7

AB ----

A      B        C,D, .......

30

70

VIIIB    VIIIB

1

FIG. 8A

AB

70

60

50A

40A

30A

20A

10

50B

40B

30B

20B

FIG. 8B

Europäisches
Patentamt

European
Patent Office

Office européen
des brevets

## EUROPEAN SEARCH REPORT

**Application Number**

EP 17 16 6454

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | CN 105 140 398 A (UNIV NANJING) 9 December 2015 (2015-12-09) * the whole document * | 1-17 | INV. H01L31/0224 H01L51/00 H01L51/44 H01L31/0352 H01L31/0749 |
| A | WO 2016/038825 A1 (SHARP KK [JP]) 17 March 2016 (2016-03-17) * paragraph [0003]; figure 1B * | 1,9 | |
| A | US 2015/123094 A1 (KANG TAE-SIK [US]) 7 May 2015 (2015-05-07) * the whole document * | 1-17 | |
| E | WO 2017/060700 A1 (UNIV OXFORD INNOVATION LTD [GB]) 13 April 2017 (2017-04-13) * the whole document * | 1 | |

TECHNICAL FIELDS
SEARCHED      (IPC)

H01L

The present search report has been drawn up for all claims

| Place of search | Date of completion of the search | Examiner |
|---|---|---|
| Berlin | 20 September 2017 | Persat, Nathalie |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 17 16 6454

This annex lists the patent family members relating to the patent documents cited in the above-mentioned European search report.
The members are as contained in the European Patent Office EDP file on
The European Patent Office is in no way liable for these particulars which are merely given for the purpose of information.

20-09-2017

| Patent document cited in search report | | Publication date | Patent family member(s) | | Publication date |
|---|---|---|---|---|---|
| CN 105140398 | A | 09-12-2015 | NONE | | |
| WO 2016038825 | A1 | 17-03-2016 | NONE | | |
| US 2015123094 | A1 | 07-05-2015 | CN | 104272486 A | 07-01-2015 |
| | | | EP | 2833427 A1 | 04-02-2015 |
| | | | JP | 5999258 B2 | 28-09-2016 |
| | | | JP | 2015525461 A | 03-09-2015 |
| | | | KR | 20130125737 A | 19-11-2013 |
| | | | US | 2015123094 A1 | 07-05-2015 |
| | | | WO | 2013169047 A1 | 14-11-2013 |
| WO 2017060700 | A1 | 13-04-2017 | NONE | | |

EPO FORM P0459

For more details about this annex : see Official Journal of the European Patent Office, No. 12/82

**REFERENCES CITED IN THE DESCRIPTION**

**Patent documents cited in the description**

- CN 105140398